# DEMANDE DE BREVET EUROPEEN

(11) **EP 2 110 360 A2**
(43) Date de publication de la demande: **21.10.2009**
(21) Numéro de dépôt: 09157933.4
(22) Date de dépôt: 15.04.2009
(51) Int. Cl.: B81C 1/00

(54) **Procédé de préparation d'un film polymérique présentant en surface des motifs nanométriques et microstructure dans son épaisseur sur tout ou partie de celui-ci selon un système particulier**

(30) Priorité: 18.04.2008 FR 0852647
(71) Demandeur: Commissariat à l'Energie Atomique, Bâtiment D "Le Ponant" 25 rue Leblanc 75015 Paris (FR)
(72) Inventeur: Landis, Stéfan, 38500, VOIRON (FR)
(74) Mandataire: Ilgart, Jean-Christophe

(57) **Abrégé**

L'invention a trait à un procédé de préparation d'un film polymérique présentant en surface des motifs nanométriques et étant microstructuré dans son épaisseur sur tout ou partie de celui-ci selon un système particulier comprenant les étapes suivantes :
- une étape de choix d'au moins un copolymère bloc apte à se microstructurer selon le système particulier susmentionné à une température et selon au moins une épaisseur prédéterminée, ladite épaisseur prédéterminée correspondant à l'épaisseur du film pour tout ou partie duquel on souhaite la microstructuration selon le système particulier susmentionné ;
- une étape de choix d'au moins un moule apte à conférer, après application sur un film comprenant ledit copolymère bloc, l'épaisseur prédéterminée et lesdits motifs nanométriques; et
- une étape d'application dudit moule sur un film comprenant ledit copolymère bloc tout en chauffant à ladite température prédéterminée, moyennant quoi l'on obtient ledit film défini en objet.

## Description

### DOMAINE TECHNIQUE

L'invention a trait à un procédé de préparation d'un film polymérique présentant en surface des motifs nanométriques et microstructuré dans son épaisseur sur tout ou partie de celui-ci selon un système particulier, ce procédé tirant partie de la capacité de copolymères blocs à s'organiser selon des systèmes particuliers.
Ce procédé peut trouver son application dans la réalisation de supports de stockage de l'information de très grande capacité (par exemple, pour les disques durs magnétiques ou les disques optiques), de membranes de filtration, de moules destinés à la mise en oeuvre des techniques de nanoimpression ou encore pour la réalisation d'interconnexions dans le domaine de la microélectronique ou nanoélectrique.

### ÉTAT DE LA TECHNIQUE ANTÉRIEURE

Les besoins de procédés pour réaliser des objets présentant des motifs nanométriques ont fortement augmenté ces dix dernières années, et ce en raison de la tendance à la miniaturisation des composants, notamment en vue d'augmenter la capacité de stockage (par exemple, pour les disques durs magnétiques ou les disques optiques) ou encore d'accroître la qualité de certains dispositifs (tels que les appareils photos numériques, les écrans plats).

Classiquement, ces objets sont réalisés par lithographie, à savoir par des techniques qui permettent de reproduire, dans une résine déposée à la surface d'un matériau, le motif que l'on désire imprimer.
Différents outils d'impression peuvent être utilisés parmi lesquels on peut citer :
- un faisceau lumineux, auquel cas on parle de lithographie optique ;
- un faisceau d'électrons, auquel cas on parle de lithographie par faisceau électronique ; ou encore
- un faisceau d'ions, auquel cas on parle de lithographie par faisceau ionique.

Si ces techniques permettent de réaliser en surface d'une résine des motifs nanométriques, elles n'induisent pas pour autant la microstructuration spécifique de la résine dans son épaisseur.

Or il se trouve que pour certaines applications, il peut s'avérer important, outre le fait de réaliser des motifs nanométriques, de conférer parallèlement au matériau servant de base à la réalisation des motifs une microstructure spécifique dans son épaisseur, telle qu'un système lamellaire, un système sphérique, un système cylindrique, un système micellaire.
Il existe donc un véritable besoin pour un procédé permettant l'obtention d'un film polymérique présentant à sa surface des motifs nanométriques et une microstructure selon un système particulier et recherché en fonction de l'application ultérieure du film, dans son épaisseur et sur tout ou partie de celui-ci.

### EXPOSÉ DE L'INVENTION

Les auteurs de l'invention ont découvert, de façon avantageuse, qu'en utilisant un type de polymère particulier pour la constitution du film et une technique d'impression de motifs particulière, il était possible de réaliser sur un film des motifs nanométriques tout en conférant audit film une microstructure selon un système particulier dans son épaisseur et sur tout ou partie de celui-ci.
Ainsi, l'invention a trait à un procédé de préparation d'un film polymérique présentant en surface des motifs nanométriques et étant microstructuré dans son épaisseur sur tout ou partie de celui-ci selon un système particulier comprenant les étapes suivantes :
- une étape de choix d'au moins un copolymère bloc apte à se microstructurer selon le système particulier susmentionné à une température et selon au moins une épaisseur prédéterminée, ladite épaisseur prédéterminée correspondant à l'épaisseur du film pour tout ou partie duquel on souhaite la microstructuration selon le système particulier susmentionné ;
- une étape de choix d'au moins un moule apte à conférer, après application sur un film comprenant ledit copolymère bloc, l'épaisseur prédéterminée et lesdits motifs nanométriques; et
- une étape d'application dudit moule sur un film comprenant ledit copolymère bloc tout en chauffant à ladite température prédéterminée, moyennant quoi l'on obtient ledit film défini en objet.

Avant d'entrer plus en détail dans la description, nous proposons les définitions suivantes.

On entend classiquement au sens de « motifs nanométriques » une structure en relief dont l'une au moins des dimensions (hauteur, longueur et/ou largeur) peut aller de 1 à 100 nm.
Des exemples particuliers de motifs nanométriques peuvent être des tranchées, des creux de forme rectangulaire, circulaire, carrée, des structures concentriques.

On entend classiquement par microstructure, la manière dont les éléments constitutifs d'un matériau s'organisent de façon géométrique, à une échelle où ils ne sont observables que par microscopie ou des techniques spécialisées (telles que la microscopie à balayage électronique).

On entend classiquement par épaisseur la mesure de la dimension du film reflétant la partie située entre les deux surfaces du film, à savoir la surface inférieure et la surface supérieure de celui-ci. Dans notre cas, le film obtenu par le procédé de l'invention ne présente pas une épaisseur uniforme du fait de la présence de motifs nanométriques.

Ainsi, l'homme du métier souhaitant obtenir un film présentant des motifs nanométriques particuliers et une microstructuration particulière dans son épaisseur sur tout ou partie de celui-ci commencera par faire un choix sur le copolymère bloc, ce choix étant fait de sorte à ce que ledit copolymère puisse présenter la microstructuration recherchée pour au moins une épaisseur de film prédéterminée (après un traitement thermique à la température prédéterminée), ladite épaisseur de film prédéterminée correspondant à celle du film, pour lequel on souhaite obtenir une microstructuration sur tout ou partie de celui-ci. Une fois le copolymère bloc choisi, on choisira le moule adapté apte à conférer par application de celui-ci sur un film comprenant ledit copolymère bloc, à la fois les motifs nanométriques et l'épaisseur voulue.
Les auteurs ont ainsi tiré partie des propriétés d'organisation des copolymères blocs.
On précise que, par copolymère bloc, on entend un polymère comprend au moins un premier bloc et au moins un second bloc, ledit premier bloc et ledit second bloc étant de nature chimique différente reliés entre eux par une liaison covalente. Sous l'action de la température et pour une épaisseur de film donnée, les chaînes de copolymères gagnent de la mobilité et finissent par se ségréguer, conduisant ainsi à minimiser les « hétérocontacts » entre les segments de nature chimique différente. Pour une température et une épaisseur prédéterminées, les films résultants vont présenter, dans leur épaisseur, une microstructure organisée pouvant correspondre à un système particulier.
L'épaisseur prédéterminée peut être comprise entre 1 nm et 1 µm et la température peut être comprise entre 20°C et 250°C.
Le système, selon lequel le film peut être microstructuré en tout ou partie selon son épaisseur, peut être un système lamellaire, un système cylindrique, un système sphérique ou un système micellaire.

On précise que, par système lamellaire, on entend un système d'organisation des éléments constitutifs du film, visibles, par exemple, par imagerie au microscope à balayage électronique, de sorte que ces éléments apparaissent sous forme de lamelles alignées.

On précise que, par système cylindrique, on entend un système d'organisation des éléments constitutifs du film, visibles, par exemple, par imagerie au microscope à balayage électronique, de sorte que ces éléments apparaissent sous forme de cylindres.

On précise que, par système sphérique, on entend un système d'organisation des éléments constitutifs du film, visibles, par exemple, par imagerie au microscope à balayage électronique, de sorte que ces éléments apparaissent sous forme de sphérules.

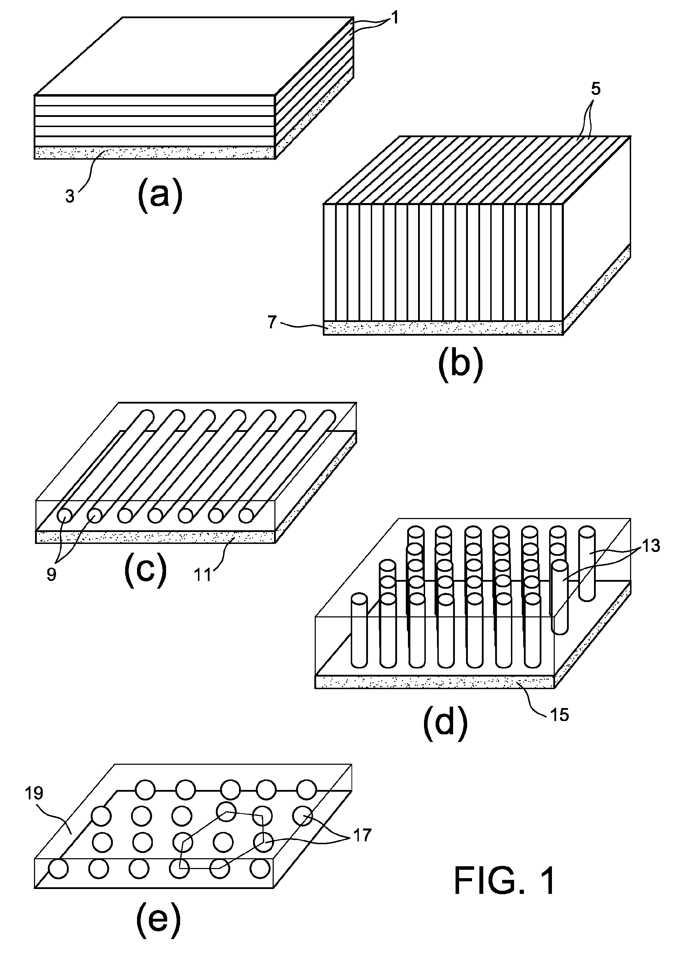

On précise que, par système micellaire, on entend un système d'organisation des éléments constitutifs du film, visibles, par exemple, par imagerie au microscope à balayage électronique, de sorte que ces éléments apparaissent sous forme de micelles.
De tels systèmes sont représentés sur la figure 1, où :
- la figure 1 (a) illustre un système lamellaire où les lamelles 1 sont disposées parallèlement au plan d'un substrat de référence sous-jacent 3 ;
- la figure 1 (b) illustre un système lamellaire où les lamelles 5 sont disposées perpendiculairement au plan d'un substrat de référence sous-jacent 7 ;
- la figure 1 (c) illustre un système cylindrique où les cylindres 9 sont disposés parallèlement au plan d'un substrat de référence sous-jacent 11 ;
- la figure 1 (d) illustre un système cylindrique où les cylindres 13 sont disposés perpendiculairement au plan d'un substrat de référence sous-jacent 15 ;
- la figure 1 (e) illustre un système sphérique où les sphérules 17 sont disposées dans le film 19 selon un réseau hexagonal.

Les systèmes peuvent varier selon le traitement de température appliqué et l'épaisseur donnée du film.

Si l'on veut obtenir un film pouvant présenter un système lamellaire, on pourra, après avoir éventuellement déterminé la température appropriée et l'épaisseur appropriée pour obtenir un tel système (si de telles données ne sont pas déjà disponibles), choisir les copolymères blocs parmi les suivants :
PS-b-PBMA, PS-b-PMMA, PS-b-P2VP, PB-b-PEO, PS-b-PB, PS-b-PI-b-PS, PVPDMPS-b-PI-b-PVPDMPS, PS-b-P2VP-b-PtBMA

PS signifiant polystyrène, PBMA signifiant polyméthacrylate de n-butyle, PMMA signifiant polyméthacrylate de méthyle, P2VP signifiant poly(2-vinylpyridine), PB signifiant polybutadiène, PEO signifiant polyéthylèneoxyde, PVPDMPS signifiant poly(4-vinylphényldiméthyl-2-propoxysilane), PI signifiant polyisoprène, PtBMA signifiant polyméthacrylate de t-butyle.

Si l'on veut obtenir un film pouvant présenter un système cylindrique, on pourra, après avoir éventuellement déterminé la température appropriée et l'épaisseur appropriée pour obtenir un tel système (si de telles données ne sont pas déjà disponibles), choisir les copolymères blocs parmi les suivants :
PFDMS-b-PDMS, PS-b-P2VP, PS-b-PMMA, PS-b-PEP, PS-b-PE, PS-b-PB, PS-b-PEO, PS-b-PB-b-PS, PαMS-b-PHS, PS-b-PI, PI-b-PFDMS, PS-b-PFDMS, PS-b-PFEMS, PtBA-b-PCEMA, PS-b-PLA, PCHE-b-PLA, pαMS-b-PHS, PPDS-b-P4VP
PFDMS signifiant poly(ferrocényldiméthylsiloxane), PDMS signifiant polydiméthylsiloxane, PS signifiant polystyrène, P2VP signifiant poly(2-vinylpyridine), PMMA signifiant polyméthacrylate de méthyle, PEP signifiant poly(éthylène-alt-propylène), PE signifiant polyéthylène, PEO signifiant polyéthylèneoxyde, PB signifiant polybutadiène, PαMS signifiant poly(α-méthylstyrène), PHS signifiant poly(4-hydroxystyrène), PI signifiant polyisoprène, PFEMS signifiant polyferrocenyléthylméthylsilane, PtBA signifiant polyacrylate de tert-butyle, PCEMA signifiant poly(cinnamoyl-éthylméthacrylate), PLA signifiant polylactide, PCHE signifiant polycyclohexylethylene, PPDS signifiant polystyrène modifié par un pentadécylphénol, P4VP signifiant poly(4-vinylpyridine).

Par alt, on entend un polymère présentant des motifs répétitifs alternés. Par exemple, pour poly(éthylène-alt-propylène), on entend un polymère présentant, dans son squelette, une alternance entre des motifs éthylène et des motifs propylène.

Si l'on veut obtenir un film pouvant présenter un système sphérique, on pourra, après avoir éventuellement déterminé la température appropriée et l'épaisseur appropriée pour obtenir un tel système (si de telles données ne sont pas déjà disponibles), choisir les copolymères blocs parmi les suivants :
PS-b-PMMA, PS-b-P2VP, PS-b-PFDMS, PS-b-PI, PS-b-PtBA, polylysine-b-polycystéine,
PS signifiant polystyrène, PMMA signifiant polyméthacrylate de méthyle, P2VP signifiant poly(2-vinylpyridine), PFDMS signifiant poly(ferrocényldiméthylsiloxane), PI signifiant polyisoprène, PtBA signifiant polyacrylate de t-butyle.

Si l'on veut obtenir un film pouvant présenter un système micellaire, on pourra, après avoir éventuellement déterminé la température appropriée et l'épaisseur appropriée pour obtenir un tel système (si de telles données ne sont pas déjà disponibles), choisir les copolymères blocs parmi les suivants :
PS-b-P2VP, PEO-b-PPO-b-PEO, PB-b-PVP, PPQ-b-PS, PDOPPV-b-PS, PS-b-PPP

PS signifiant polystyrène, P2VP signifiant poly(2-vinylpyridine), PEO signifiant polyéthylèneoxyde, PPO signifiant polypropylèneoxyde, PB signifiant polybutadiène, PVP signifiant poly(butadiène-b-vinylpyridinium), PPQ signifiant polyphénylquinoxaline, PDOPPV signifiant poly(2,5-dioctyl-p-phénylènevinylène), PPP signifiant polyparaphénylène.

Une fois l'étape de choix du copolymère bloc effectuée, on effectue un choix sur le moule à utiliser, de sorte que l'application du moule sur un film comprenant ledit copolymère bloc confère au film les motifs nanométriques souhaités et l'épaisseur voulue, sachant que le moule devra conférer au film au moins une épaisseur prédéterminée pour laquelle le film présentera une structuration selon un système recherché après application de la température adéquate (appelée température prédéterminée). En d'autres termes, le moule sera choisi de sorte à ce que sa topographie réponde aux besoins visés d'organisation du film polymère.
Le procédé de l'invention peut comprendre, en outre, s'il n'est pas disponible, une étape de réalisation du moule, ce moule pouvant être réalisé par des techniques de lithographie classique (lithographie optique, électronique, par rayons X, par faisceau ionique ou par pointe ASM), le moule étant réalisé de sorte à pouvoir conférer après application les motifs nanométriques voulus et l'épaisseur voulue au film que l'on souhaite obtenir.

Le moule peut être avantageusement dimensionné, de sorte à ce que le film obtenu après application dudit moule ne présente pas de joints de grains, c'est-à-dire que l'orientation des plans de réseau cristallin entre deux grains ne diffère pas. Des essais préalables pour obtenir cet effet peuvent être mis en oeuvre avant la réalisation du procédé de l'invention.

Enfin, le procédé comprendra une étape d'application dudit moule choisi sur le film, la température étant portée à une température prédéterminée, cette température étant nécessaire pour la microstructuration du film selon le système attendu. Cette étape d'application peut être qualifiée d'étape de nanoimpression.

Avant l'étape d'application, le procédé de l'invention peut comprendre une étape de dépôt du film comprenant le copolymère bloc sur un substrat selon des techniques classiques de dépôt.
Selon le procédé de l'invention, il peut être également envisageable d'utiliser deux moules distincts, pouvant être appliqués de sorte à prendre le film en étau.

En résumé, d'un point de vue pratique, la stratégie de mise en oeuvre du procédé peut être la suivante :
- en fonction de l'application visée et donc de la microstructure recherchée, on choisira un copolymère bloc (dibloc, tribloc, ..etc) apte à présenter la microstruture selon le système que l'on souhaite obtenir ;
- le polymère étant choisi, si l'utilisateur ne sait pas pour quelle(s) épaisseur(s) et température le polymère est apte à former la microstructure susmentionnée, il pourra alors mettre en place une première expérience, ce afin de déterminer ces données (épaisseur(s) et température) ; pour ce faire, on déposera le polymère sur un substrat plan sous forme d'un film (sans les imprimer), en réalisant le procédé thermodynamique classique (en chauffant à différentes températures). On peut réaliser cette expérience avec plusieurs épaisseurs de polymère, pour ainsi déterminer les couples de valeurs (épaisseur, température de traitement) permettant d'accéder à la microstructure voulue. Les données d'épaisseur permettront par la suite de déterminer les règles de dessin pour la fabrication, si nécessaire, du moule ;
- le cas échéant, la réalisation du moule, avantageusement en silicium ou silice (résolution latérale, profondeur, forme des motifs) ; les règles de dessin étant connues, la fabrication est effectuée avec des techniques de lithographie classiques (lithographie optique, lithographie électronique, lithographie aux rayons X, lithographie par faisceau ionique) ;
- l'application du moule sur le film, éventuellement déposé sur un substrat.

Ainsi, le procédé de l'invention comprend les avantages suivants :
- possibilité de maîtriser l'extension spatiale et la position des zones microstructurées selon le système voulu grâce au choix du copolymère bloc et du moule approprié ;
- possibilité de contrôler localement et sur une grande surface (qui peut correspondre à la surface du moule ou à une surface inférieure à celui-ci, selon l'objectif recherché) de l'épaisseur du film polymérique, et par voie de conséquence, la microstructure résultant, après traitement thermique, de l'épaisseur conférée au film par l'application du moule ;
- possibilité de réutilisation du moule un très grand nombre de fois, contrairement au technique de graphoépitaxie, par exemple, où le moule n'est qu'à usage unique.

Le procédé de l'invention permet de ce fait de surmonter les inconvénients des techniques utilisées dans l'art antérieur, telles que :
- la technique de la graphoépitaxie, qui nécessite le dépôt du film à structurer sur un substrat présentant une topographie, cette technique se révélant coûteuse car le substrat susmentionné ne peut être qu'à usage unique ;
- la technique consistant à assurer la microstructuration des polymères selon un système particulier, grâce à l'utilisation d'un champ électrique, cette technique s'avérant inefficace pour organiser la microstructure d'un polymère sur de grandes surfaces.

D'autres avantages et caractéristiques de l'invention apparaîtront à la lecture des modes de réalisation particuliers, en référence aux figures annexées.

### BRÈVE DESCRIPTION DES DESSINS

La figure 1 représente différents systèmes selon lesquels un polymère bloc peut s'organiser.

La figure 2 représente, sous forme d'un schéma en coupe, les différentes étapes du procédé de l'invention selon un mode de réalisation particulier de l'invention.

Les figures 3 et 4 représentent deux configurations de moules différents.

La figure 5 représente un second mode de réalisation de l'invention avec mise en jeu de deux moules (vue en coupe).

La figure 6 représente une variante avec mise en jeu de deux moules complexes (vue en coupe).

La figure 7 représente un exemple d'application du procédé de l'invention à la réalisation d'interconnexions électroniques.

### EXPOSÉ DÉTAILLÉ DE MODES DE RÉALISATION PARTICULIERS

Cet exposé va décrire différents modes de réalisation du procédé de l'invention, axés notamment sur la configuration des moules utilisés et le nombre de ceux-ci.

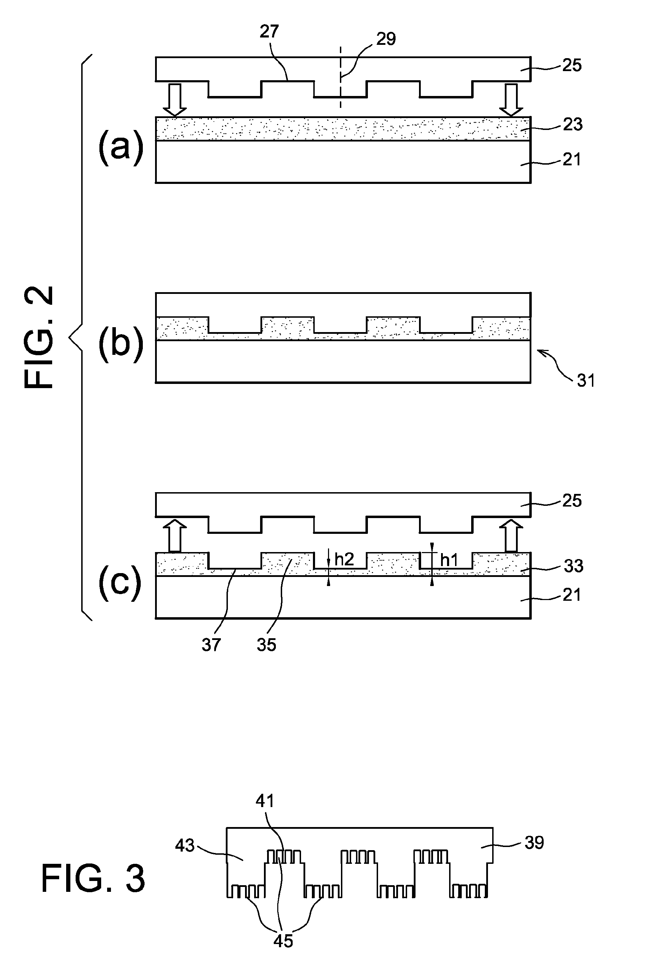

Le premier mode de réalisation va tout d'abord être décrit. Sur la figure 2 sont représentées les différentes étapes du procédé de l'invention mettant en oeuvre un seul moule, avec :
- sur la figure 2a, un substrat 21 recouvert d'un film 23 comprenant un copolymère bloc et un moule 25 comprenant deux types de motifs (respectivement motif 27 et motif 29), ce moule présentant en coupe un profil en créneaux ;
- sur la figure 2b, l'ensemble 31 formé du substrat, du film et du moule après application de celui-ci sur le film ; et
- sur la figure 2c, le substrat 21 recouvert du film modifié 33 après application du moule 25, ce film présentant deux types de motifs 35 et 37, conférant respectivement au film une épaisseur haute h1 et une épaisseur basse h2.

Le film ainsi imprimé peut correspondre à différentes configurations possibles :
- une microstructuration selon un système particulier (par exemple, un système lamellaire) sur tout le film, le moule permettant de conférer une épaisseur permettant le maintien du système voulu sur l'entièreté du film, l'épaisseur ayant des dimensions multiples l'une de l'autre, afin de conserver la périodicité de l'organisation ;
- une microstructuration selon un système particulier (par exemple un système lamellaire) sous un motif (épaisseur haute h1 ou épaisseur basse h2) et une absence d'organisation selon un système particulier sous un autre motif (épaisseur haute h1 ou épaisseur basse h2) ;
- une microstructuration selon un système particulier (par exemple un système lamellaire) sous un motif (par exemple épaisseur haute h1) et une microstructuration selon un autre système(par exemple, un système cylindrique) sous un autre motif (par exemple épaisseur basse h2), cette configuration étant rendue possible par l'utilisation d'un copolymère bloc apte à adopter deux systèmes cristallins différents pour deux épaisseurs de film différentes pour un traitement thermique à une même température (ce qui est le cas, par exemple du PS-b-PMMA).

Ainsi, en choisissant les dimensions des motifs 35 et 37 susmentionnés et eu égard aux caractéristiques du copolymère bloc constitutif du film, il est ainsi possible de parfaitement maîtriser l'extension spatiale et la position des zones microstructurées selon un système voulu.

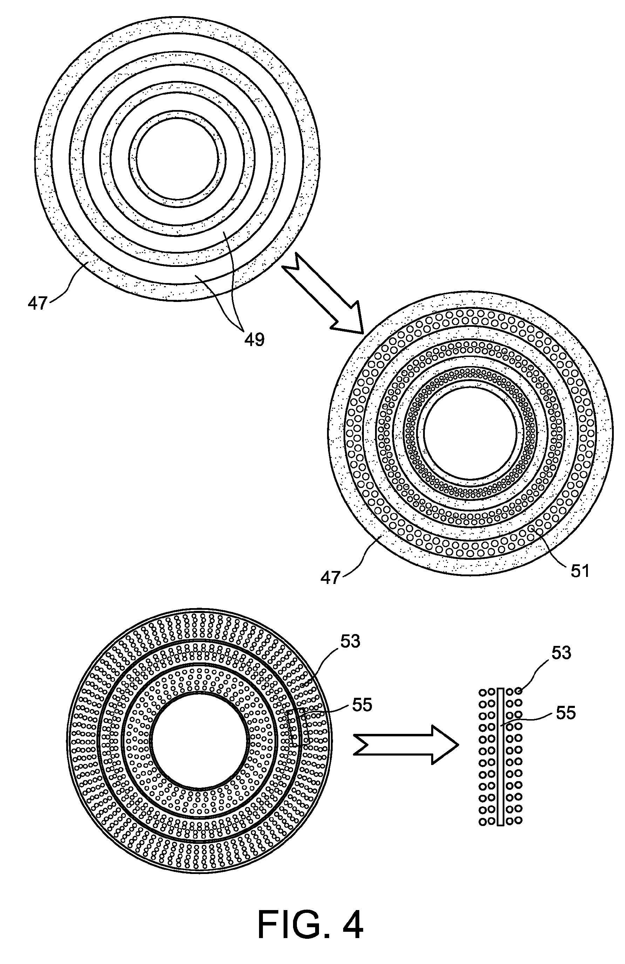

Les figures 3 et 4 représentent deux variantes mettant en oeuvre un seul moule :
- sur la figure 3, un moule 39 présentant, en coupe, un profil en créneaux, dont les creux 41 et les sommets 43 sont pourvus de crêtes 45 ;
- sur la figure 4, un moule circulaire 47 présentant des espaces de moulage concentrique 49.

Dans le premier cas, le procédé permet l'obtention d'un film présentant des motifs nanométriques comprenant au moins deux niveaux de topographie : un premier niveau consistant en le profil en créneaux et le second niveau consistant en les crêtes prévues sur les sommets et les creux du premier niveau. Le film peut être microstructuré selon un système adéquat sur l'entièreté de celui-ci (par exemple, système lamellaire) ou uniquement sur certaines zones (par exemple, selon l'épaisseur haute ou basse du film).

Dans le second cas, outre les motifs concentriques obtenus, la mise en oeuvre du procédé de l'invention avec ce type de moule permet l'obtention d'un film microstructuré selon un système particulier et présentant une densité très importante de zones microstructurées selon le système voulu (par exemple supérieure à 1 Terabit/inch²) (référence 51 sur la figure 4). En diminuant la taille des zones non organisées sur le système recherché, on peut également réaliser une organisation des domaines qui, les uns par rapport aux autres, présenteront une phase microstructurée dans le système recherché avec une minimisation des zones de joints de grain (voir figure 4 représentant les zones concentriques organisées selon le système voulu 53 et les zones non organisées 55 de taille très limitée). Il peut être ainsi envisagé de réaliser des supports de stockage de l'information de très grande capacité (stockage magnétique, optique).

Selon un deuxième mode de réalisation, il est procédé à l'utilisation de deux moules, le film de polymère étant pris en étau entre ces deux moules.
Ces moules peuvent être identiques comme cela est représenté :

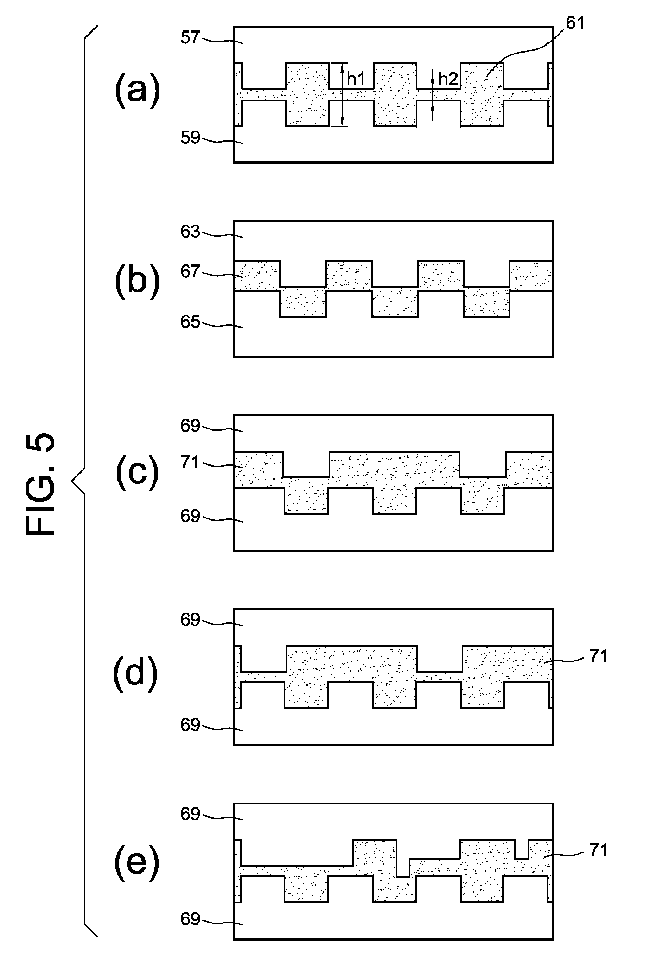

- sur la figure 5a, où deux moules identiques 57 et 59 sont disposés en vis-à-vis et prennent en étau un film polymérique 61, générant ainsi des motifs de hauteurs h1 et h2 microstructurées selon un système cristallin souhaité ;
- sur la figure 5b, où deux moules identiques 63 et 65 sont disposés de façon décalée de part et d'autre d'un film polymérique 67.

Ces moules peuvent être différents comme cela est représenté sur les figures 5c à 5d (références 69 pour les moules et 71 pour le film).

Il ressort ainsi de ce mode de réalisation qu'il est possible de créer une infinité de configurations possibles et de domaines organisés selon un système cristallin voulu sous réserve de choisir le copolymère bloc approprié apte à cristalliser selon le système voulu pour les épaisseurs de motifs conférées par les moules.

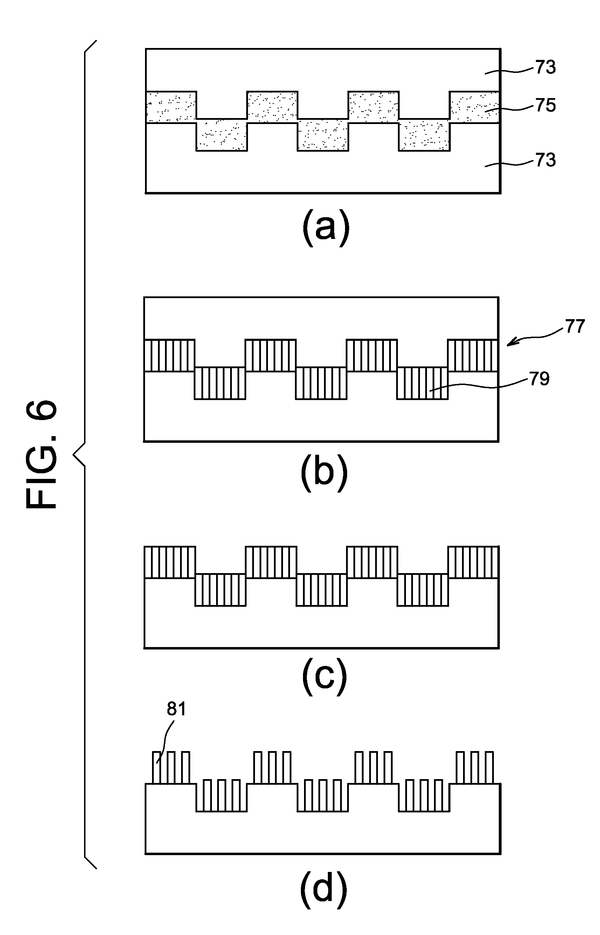

Un exemple particulier d'utilisation de deux moules pour créer des motifs complexes est représenté sur la figure 6 où :
- sur la figure 6a, deux moules identiques 73 prennent en étau un film polymérique 75 constitué de deux copolymères blocs aptes à cristalliser selon un système lamellaire pour les épaisseurs de motifs conférées par l'application des deux moules ;
- sur la figure 6b, l'ensemble 77 formé par les deux moules et le film pris en étau, cet ensemble étant porté à une température prédéterminée pour cristalliser le film selon un système lamellaire 79 ;
- sur la figure 6c, le retrait du moule supérieure 73 ;
- sur la figure 6d, le retrait sélectif d'un polymère par rapport à l'autre, laissant subsister ainsi des motifs nanométriques 81.

Il peut être possible selon le procédé de l'invention de graver la géométrie créée dans le film de polymère dans le substrat qui supporte le film.

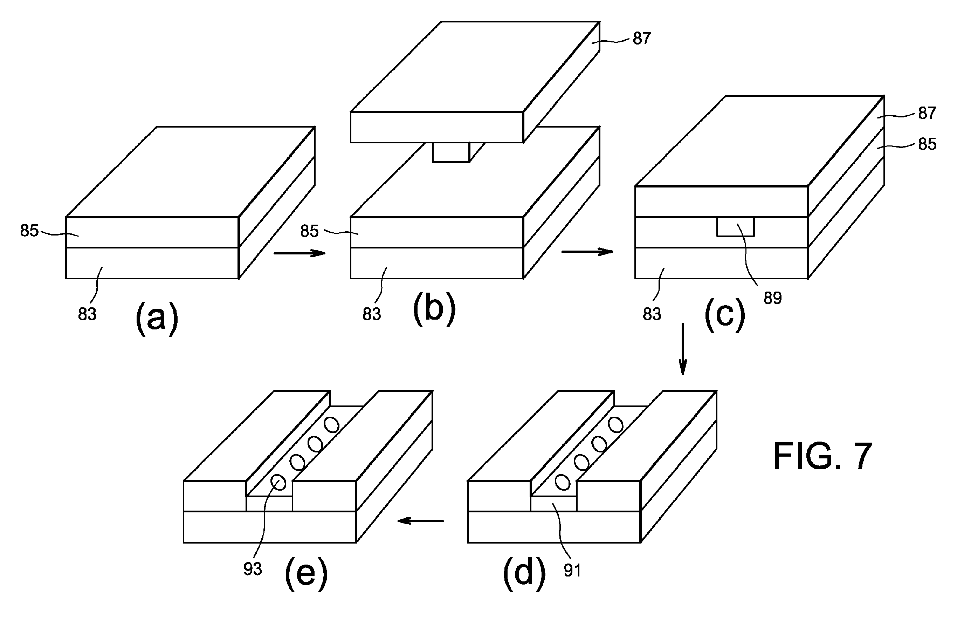

Le procédé de l'invention peut être mis en oeuvre dans de très nombreux domaines d'application, parmi lesquelles l'on peut citer :
- la réalisation de supports de stockage de l'information (tel que le stockage magnétique, le stockage optique) ;
- la réalisation de pièces présentant une surface texturée, notamment pour modifier ses propriétés de mouillabilité (par exemple, pour des verres auto-nettoyants), d'adhérence ou pour des applications biologiques ;
- la réalisation de membranes présentant des nanopores pour des systèmes de filtration ;
- la réalisation de moules, notamment pour la mise en oeuvre de techniques d'impression telles que la nanoimpression ;
- la réalisation d'interconnexions pour des applications électroniques, cette application étant représentée sur la figure 7.

Plus précisément, la figure 7 représente les différentes étapes de réalisation d'interconnexions destinées à relier un niveau diélectrique inférieure à des éléments conducteurs.

Ainsi, sur la figure 7a est représenté un substrat 83 constituant le niveau diélectrique destiné à être relié à des éléments conducteurs, recouvert par un film 85 constitué d'un mélange de deux copolymères diblocs, dont un des copolymères est apte à se microstructurer pour une épaisseur prédéterminée (ici l'épaisseur sous le motif généré par l'application du moule) et une température prédéterminée selon un système particulier, en l'occurrence ici un système sphérique (c'est-à-dire l'un des polymères s'organise sous forme de sphérules).
Sur ce film 85 est appliqué, conformément à ce qui est représenté aux figures 7b et 7c, un moule 87 destiné après application à former un motif sous forme de travée centrale 89 sur le film, l'ensemble étant chauffé à la température prédéterminée nécessaire à la microstructuration d'un des polymères selon un système sphérique.
Le moule est ensuite retiré et il résulte sous le motif en forme de travée centrale une microstructuration partielle du film selon un système sphérique (référence 91 sur la figure 7d). Le polymère responsable de cette microstructuration est ensuite éliminé par un traitement approprié, laissant subsister des trous traversants 93 (figure 7e), ces trous permettant de réaliser des contacts de connexion, par exemple, en remplissant les cavités ainsi formées par un élément conducteur.

## Revendications

1. Procédé de préparation d'un film polymérique présentant en surface des motifs nanométriques et étant microstructuré dans son épaisseur sur tout ou partie de celui-ci selon un système particulier comprenant les étapes suivantes :
- une étape de choix d'au moins un copolymère bloc apte à se microstructurer selon le système particulier susmentionné à une température et selon au moins une épaisseur prédéterminée, ladite épaisseur prédéterminée correspondant à l'épaisseur du film pour tout ou partie duquel on souhaite la microstructuration selon le système particulier susmentionné ;
- une étape de choix d'au moins un moule apte à conférer, après application sur un film comprenant ledit copolymère bloc, l'épaisseur prédéterminée et lesdits motifs nanométriques; et
- une étape d'application dudit moule sur un film comprenant ledit copolymère bloc tout en chauffant à ladite température prédéterminée, moyennant quoi l'on obtient ledit film défini en objet.

2. Procédé selon la revendication 1, dans lequel le système est choisi parmi un système lamellaire, un système cylindrique, un système sphérique ou un système micellaire.

3. Procédé selon la revendication 2, dans lequel, pour avoir un système lamellaire, le copolymère bloc est choisi parmi les copolymères blocs suivants:
PS-b-PBMA, PS-b-PMMA, PS-b-P2VP, PB-b-PEO, PS-b-PB, PS-b-PI-b-PS, PVPDMPS-b-PI-b-PVPDMPS, PS-b-P2VP-b-PtBMA,
PS signifiant polystyrène, PBMA signifiant polyméthacrylate de n-butyle, PMMA signifiant polyméthacrylate de méthyle, P2VP signifiant poly(2-vinylpyridine), PB signifiant polybutadiène, PEO signifiant polyéthylèneoxyde, PVPDMPS signifiant poly(4-vinylphényldiméthyl-2-propoxysilane), PI signifiant polyisoprène, PtBMA signifiant polyméthacrylate de t-butyle.

4. Procédé selon la revendication 2, dans lequel, pour avoir un système cylindrique, le copolymère bloc est choisi parmi les copolymères blocs suivants :
PFDMS-b-PDMS, PS-b-P2VP, PS-b-PMMA, PS-b-PEP, PS-b-PE, PS-b-PB, PS-b-PEO, PS-b-PB-b-PS, PαMS-b-PHS, PS-b-PI, PI-b-PFDMS, PS-b-PFDMS, PS-b-PFEMS, PtBA-b-PCEMA, PS-b-PLA, PCHE-b-PLA, PαMS-b-PHS, PPDS-b-P4VP
PFDMS signifiant poly(ferrocényldiméthylsiloxane), PDMS signifiant polydiméthylsiloxane, PS signifiant polystyrène, P2VP signifiant poly(2-vinylpyridine), PMMA signifiant polyméthacrylate de méthyle, PEP signifiant poly(éthylène-alt-propylène), PE signifiant polyéthylène, PEO signifiant polyéthylèneoxyde, PB signifiant polybutadiène, PαMS signifiant poly(α-méthylstyrène), PHS signifiant poly(4-hydroxystyrène), PI signifiant polyisoprène, PFEMS signifiant polyferrocenyléthylméthylsilane, PtBA signifiant polyacrylate de tert-butyle, PCEMA signifiant poly(cinnamoyl-éthylméthacrylate), PLA signifiant polylactide, PCHE signifiant polycyclohexylethylene, PPDS signifiant polystyrène modifié par un pentadécylphénol, P4VP signifiant poly(4-vinylpyridine).

5. Procédé selon la revendication 2, dans lequel, pour avoir un système sphérique, le copolymère bloc est choisi parmi les copolymères suivants :
PS-b-PMMA, PS-b-P2VP, PS-b-PFDMS, PS-b-PI, PS-b-PtBA, polylysine-b-polycystéine
PS signifiant polystyrène, PMMA signifiant polyméthacrylate de méthyle, P2VP signifiant poly(2-vinylpyridine), PFDMS signifiant poly(ferrocényldiméthylsiloxane), PI signifiant polyisoprène, PtBA signifiant polyacrylate de t-butyle.

6. Procédé selon la revendication 2, dans lequel, pour avoir une structure micellaire, le copolymère bloc est choisi parmi les copolymères suivants :
PS-b-P2VP, PEO-b-PPO-b-PEO, PB-b-PVP, PPQ-b-PS, PDOPPV-b-PS, PS-b-PPP
PS signifiant polystyrène, P2VP signifiant poly(2-vinylpyridine), PEO signifiant polyéthylèneoxyde, PPO signifiant polypropylèneoxyde, PB signifiant polybutadiène, PVP signifiant poly(butadiène-b-vinylpyridinium), PPQ signifiant polyphénylquinoxaline, PDOPPV signifiant poly(2,5-dioctyl-p-phénylènevinylène), PPP signifiant polyparaphénylène.

7. Procédé selon l'une quelconque des revendications précédentes, comprenant une étape de réalisation du moule.

8. Procédé selon la revendication 7, dans lequel le moule est dimensionné, de sorte à ce que le film obtenu après application dudit moule ne présente pas de joints de grains.
